Europäisches Patentamt

European Patent Office

Office européen des brevets

(19)

(11) Publication number: **0 201 713**
**A1**

(12) **EUROPEAN PATENT APPLICATION**

(21) Application number: **86104718.1**

(22) Date of filing: **07.04.86**

(51) Int. Cl.4: **H 01 L 21/285**
**H 01 L 21/265**

(30) Priority: **24.04.85 US 726559**

(43) Date of publication of application:
**20.11.86 Bulletin 86/47**

(84) Designated Contracting States:
**DE FR GB IT NL**

(71) Applicant: **MOTOROLA, INC.**
**1303 East Algonquin Road**
**Schaumburg, Illinois 60196(US)**

(72) Inventor: **Nguyen, Richard**
**2764 S. Spruce**
**Mesa Arizona 85202(US)**

(74) Representative: **Ibbotson, Harold et al,**
**Motorola Ltd Patent and Licensing Operations - Europe**
**Jays Close Viables Industrial Estate**
**Basingstoke Hampshire RG22 4PD(GB)**

(54) **Method of making a FET gate by angled evaporation.**

(57) An oxide pedestal 22A is formed for use in a self-aligning gate FET. The pedestal 22A is then used for a shadowing effect when performing ion implantation, and is used as a pedestal when performing an angled evaporation of metal. This results in a FET device wherein the gate length Lg is easy to control to provide a small gate. In addition, the metals used result in low gate resistance.

*FIG. 7*

Croydon Printing Company Ltd.

# METHOD OF MAKING A FET GATE BY ANGLED EVAPORATION

## Background of the Invention

This invention relates, in general, to field effect transistors (FET), and more particularly, to a method for making a gate for a field effect transistor by using angled evaporation.

Manufacture of a metal semiconductor field effect transistor (MESFET) consists of forming a drain, a source, and a gate on the surface of a semiconductor substrate. Metallic ohmic contacts are generally used for the drain and source electrodes whereas a rectifying Schottky barrier metal system is used for the gate electrode. A gallium arsenide (GaAs) MESFET would have a semi-insulating substrate. In manufacturing MESFETs it is desirable to have short gate lengths and low electrical resistance along the width of the gate electrode. Furthermore, it is desirable that the gate structure be compatible with self-aligning techniques to reduce the use of photomasks. One technique that has come into use to help accomplish this is the use of angled evaporation sometimes called shadow deposition. Most of these techniques consist of providing an opening in a photoresist material and then using the walls of the opening to provide the shadow effect. Using photoresist as a material to provide the shadow effect is not too satisfactory since photoresist does not always provide a smooth surface and smooth edges along the opening.

Accordingly, it is an object of the present invention to provide a new and improved method of using angled evaporation.

Another object of the present invention is to provide a FET device having low gate resistance fabricated using a self-aligning technique.

Yet a further object of the present invention is to provide a method for fabrication of a sub-micron gate for a FET without using optical lithography.

An additional object of the present invention is to provide a method for angled implanting the source and drain areas of a MESFET to achieve reduced source resistance.

Yet a further additional object of the present invention is to provide a method for fabrication of a low noise gallium arsenide FET having a reduced gate resistance.

## Summary of the Invention

The above and other objects and advantages of the present invention are provided by a method of fabricating a self-aligned gate FET. The method comprises establishing an oxide pedestal to provide a shadow effect and then using angle implantation to form implanted source and drain regions and using angled evaporation techniques to provide the metal gate.

The subject matter which is regarded as the invention is set forth in the appended claims. The invention itself, however, together with further objects and advantages thereof, may be better understood by referring to the following detailed description taken in conjunction with the accompanying drawings.

## Brief Description of the Drawings

FIGS. 1-9 illustrate in outline form the procedure followed in providing an oxide pedestal, angled implantation, and angled evaporation; and

FIG. 10 illustrates the gate length as a function of the angle.

The exemplification set out herein illustrates the preferred embodiment of the invention in one form thereof, and such exemplification is not to be construed as limiting in any manner.

## Detailed Description of the Drawings

In a field effect transistor having a self-aligned gate, the gate is formed first and used as a mask to implant the source and the drain. However, high temperatures are needed during annealing to activate the implant. This usually requires that the gate be made from a refractory metal so that it will withstand the high annealing temperature. The high refractory metal results in a gate having a high resistance which results in a poor performing transistor. The invention described hereinafter overcomes these disadvantages.

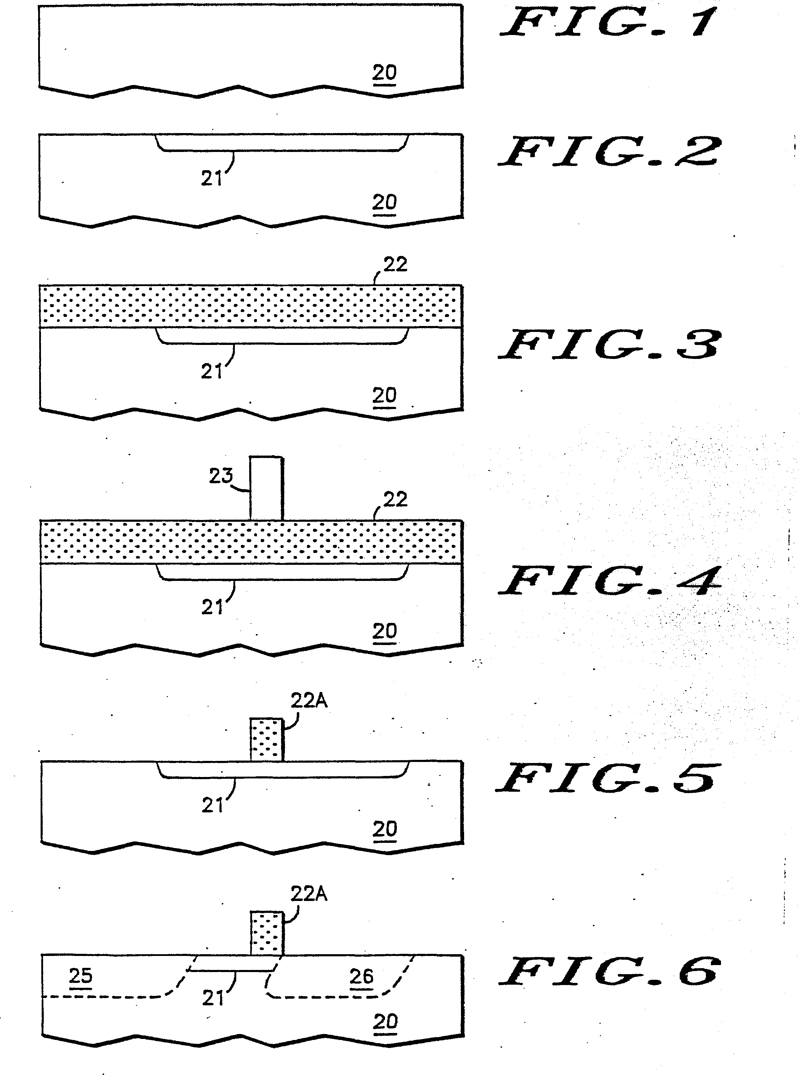

FIGS. 1-9 illustrate an improved method for fabricating a self-aligned gate MESFET. The improved method is illustrated in sufficient detail for a complete understanding of the invention; however, all the steps, which are well known to those of skill in the art, needed to complete a finished product have been omitted. Illustrated in FIG. 1 is a substrate on which the MESFET will be formed. In a preferred embodiment, substrate 20 is a semi-insulating gallium arsenide material. An N channel implant is then performed to obtain channel 21 illustrated in FIG. 2. FIG. 3 illustrates a layer of oxide 22 which is deposited over substrate 20 also covering N channel 21. A layer of photoresist is then placed over oxide layer 22 and exposed to leave a predefined pattern of photoresist 23, shown in FIG.4. Oxide layer 22, in a preferred embodiment, is silicon oxide deposited by plasma CVD. However, it will be understood that layer 22 could be any suitable gate support material such as silicon nitride or the like. By using patterned photoresist 23 as a mask, oxide layer 22 is removed leaving a pedestal 22A illustrated in FIG. 5. Pedestal 22A will serve as a gate support as will become more apparent hereinafter. In order to obtain a lower source resistance, an N+ angle implant and annealing is then performed. The low source resistance is desired in low noise FETS. The N+ angle implant results in the formation of source region 25 and drain region 26 in substrate 20 as illustrated in FIG. 6. Note that a portion of N channel 21 is left under pedestal or gate support 22A and joins regions 25 and 26.

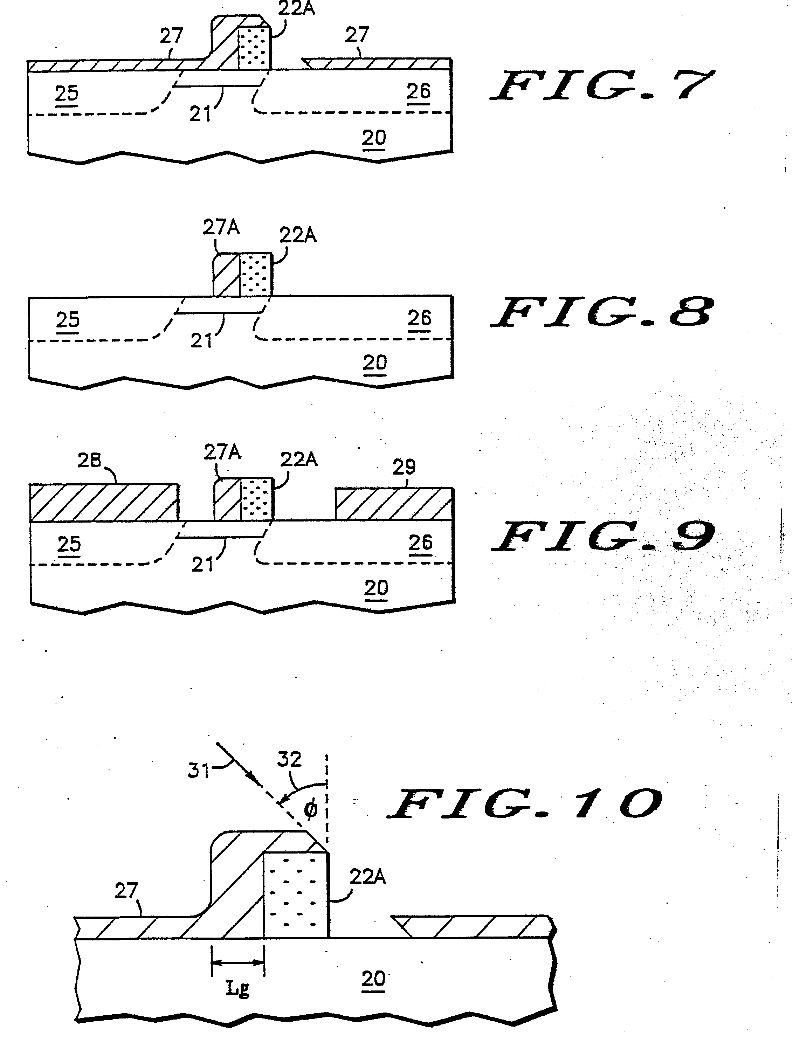

At this point an angled evaporation is performed to deposit a metal layer 27 which covers substantially all of regions 25 and 26 as well as N channel 21 and pedestal 22A as shown in FIG. 7. Those areas not covered by the angled evaporation of metal are covered by or else shadowed by gate support 22A. The angled evaporation results in a void of metal on one side of pedestal 22A and a thick deposit of metal on the opposite side of pedestal 22A. It will be noted that in a preferred embodiment of this invention metal layer 27 is evaporated in two steps. The first step consists of a thin layer of titanium (Ti), and the second step consists of angled evaporation of a layer of gold (Au). The thin layer of titanium is needed to provide a Schottky barrier for the MESFET device and the gold then provides for a low resistance gate. These two metals result in gate metal layer 27. Gate 27A is then better defined after a reactive ion etch or plasma etch of metal layer 27. The resulting gate 27A is shown in FIG. 8. Note that gate support 22A is left in place, in a preferred embodiment, since gate 27A is typically very thin and is better maintained in an erect configuration by the support of pedestal 22A. Source metal 28 along with drain metal 29 are then formed to provide ohmic contacts for the MESFET device as shown in FIG. 9.

The use of silicon oxide to provide pedestal 22A has resulted in devices having extremely well defined gates wherein the edges of the gate metal are very straight. This is because silicon oxide can be deposited with good uniformity and thickness. This is a great advantage over those fabrication processes which use photoresist to define an opening and to provide a shadowing effect. This is because silicon oxide can be controlled closer and better than photoresist.

FIG. 10 illustrates in schematic form the required evaporation angle to obtain the desired gate length. Illustrated in FIG. 10 is a substrate 20 having a pedestal or support 22A on which a layer of metal 27 has been formed through angled evaporation. The direction of the evaporation is illustrated by arrow 31 which is at an angle , shown by arrow 32 from a vertical plane perpendicular to substrate 20. The gate length (Lg) is equal to the deposition thickness times sin . The angle , of course, is the evaporation angle and the deposition thickness is achieved in the standard manner.

By now it should be appreciated that there has been provided an improved method of fabricating a MESFET device using angled evaporation. One of the advantages is that the length of the gate can be controlled to obtain a small gate. Another advantage is the low gate resistance which is achieved while maintaining low source resistance. Note in FIG. 9 that gate 27A is very close to source region 25 thereby resulting in low bulk resistance between the gate and the source. Pedestal or gate support 22A could be removed if so desired.

CLAIMS

1. A method for making a MESFET device comprising: applying a layer of oxide over a substrate which has been doped with a predetermined dopant; applying and exposing photoresist over the layer of oxide to leave a narrow section of photoresist on the layer of oxide over the dopant; etching the layer of oxide and removing the narrow section of photoresist to leave a narrow section of oxide on the substrate; performing an angled implant and annealing the angled implant to form implanted regions on both sides of the narrow section of the oxide; performing an angled evaporation of metal to provide a film of metal on the substrate and having a void of metal on one side of the narrow section of oxide and a relatively thick layer of metal on the other side of the narrow section of oxide; etching away the film of metal and leaving the relatively thick layer of metal on the side of the narrow section of oxide so that the relatively thick layer of metal performs as the gate of the MESFET device; and forming the source and drain metals for the MESFET.

2. The method of claim 1 wherein applying the oxide is performed by applying silicon oxide.

3. The method of claim 1 wherein the angled evaporation of metal is performed using a metal having gold.

4. The method of claim 1 wherein the layer of oxide is achieved by performing a deposition over a semi-insulating substrate such as GaAs.

5. A method for making a MESFET device comprising: forming a layer of oxide on a substrate having a doped channel region; etching the layer of oxide to leave a thin pedestal of oxide on a predetermined area of the substrate; angle implanting a dopant on both sides of the pedestal of oxide to form a source and a drain region in the substrate; angle evaporating gate metal on the substrate and the pedestal of oxide so that the side of the pedestal nearest the drain region is substantially void of gate metal; etching the gate metal from the substrate to leave the gate metal on the side of the pedestal of oxide which is closest to the source region; and forming source and drain metals over the source and drain regions respectively.

6. A MESFET device having a gate made by an angled evaporation process, comprising: a GaAs substrate; two metal areas formed on the GaAs substrate to serve as source and drain for the MESFET device; an oxide pedestal located between the two metal areas closest to the drain; and a thin metallic gate formed between the two metal areas by angle evaporating the metal forming the metallic gate on a side of the oxide pedestal nearest the source.

7. A method of making a self-aligned-gate MESFET, comprising:
    providing an insulating pedestal located between a source region and a drain region; evaporating gate metal at an angle against the insulating pedestal to form a gate for the MESFET; and providing source and drain metals over the source and drain regions respectively.

8. The method of claim 7 further including calculating the sin of the angle of evaporation by dividing the desired length of the gate by the thickness of the gate metal deposition.

9. The method of claim 7 wherein the step of evaporating gate metal at an angle includes depositing by evaporation layers of titanium and gold.

0201713

*FIG.1*

20

*FIG.2*

21

20

22

*FIG.3*

21

20

23

22

*FIG.4*

21

20

22A

*FIG.5*

21

20

22A

*FIG.6*

25    21    26

20

*FIG. 7*

*FIG. 8*

*FIG. 9*

*FIG. 10*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 113 059 (IBM)<br><br>* page 4, last paragraph - page 5, paragraph 2 *<br><br>--- | 1,2,5-7 | H 01 L 21/285<br>H 01 L 21/265 |
| A | IEEE ELECTRON DEVICE LETTERS, vol. EDL-3, no. 8, August 1982, pages 187-190, New York, US; P.C. CHAO et al.: "Experimental comparisons in the electrical performance of long and ultrashort gate length GaAs MESFET's"<br>* figure 1 *<br><br>--- | 1,4-7 | |
| A | IEEE TRANSACTIONS ON ELECTRON DEVICES, vol. ED-22, no. 6, June 1975, pages 358-360, New York, US; R.H. DEAN et al.: "Submicrometer self-aligned dual-gate GaAs FET"<br>* page 359, steps 6), 7) *<br><br>----- | 3,9 | |

**TECHNICAL FIELDS SEARCHED (Int. Cl.4)**

H 01 L 21/265
H 01 L 21/28

The present search report has been drawn up for all claims

| Place of search | Date of completion of the search | Examiner |
|---|---|---|
| BERLIN | 17-08-1986 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82